# FASCICULE DE BREVET EUROPEEN

(11) **EP 4 383 338 B1**
(45) Date de publication et mention de la délivrance du brevet: **05.03.2025**
(21) Numéro de dépôt: 23212491.7
(22) Date de dépôt: 28.11.2023
(51) Int. Cl.: H01L 27/15, H01L 33/20

(54) **PROCÉDÉ DE FABRICATION D'UN DISPOSITIF OPTOÉLECTRONIQUE COMPORTANT UNE LED ET UNE PHOTODIODE**
VERFAHREN ZUR HERSTELLUNG EINER OPTOELEKTRONISCHEN VORRICHTUNG MIT EINER LED UND EINER PHOTODIODE
METHOD FOR MANUFACTURING AN OPTOELECTRONIC DEVICE COMPRISING AN LED AND A PHOTODIODE

(30) Priorité: 07.12.2022 FR 2212873
(43) Date de publication de la demande: 12.06.2024
(73) Titulaire: Commissariat à l'Energie Atomique et aux Energies Alternatives, 75015 Paris (FR)
(72) Inventeur: SIMON, Julia, 38054 GRENOBLE CEDEX 09 (FR); ROL, Fabian, 38054 GRENOBLE CEDEX 09 (FR); LE MAITRE, Patrick, 38054 GRENOBLE CEDEX 09 (FR)
(74) Mandataire: Cabinet Beaumont

(56) Documents cités:
- EP-A1- 3 364 340
- EP-A1- 3 780 123
- EP-A1- 3 826 068
- US-A1- 2017 141 115

## Description

### Domaine technique

La présente description concerne de façon générale le domaine des dispositifs optoélectroniques. Elle vise plus particulièrement la réalisation d'un dispositif optoélectronique comportant au moins une diode électroluminescente (LED), et au moins une photodiode. Elle vise notamment la réalisation simultanée, au moyen d'une étape d' épitaxie commune, d'un empilement actif d'émission de LED et d'un empilement actif de réception de photodiode, destinés à fonctionner dans une même gamme de longueurs d'ondes.

### Technique antérieure

On a déjà proposé, par exemple dans le domaine des systèmes de communication optique, des dispositifs comprenant une ou plusieurs LED configurées pour émettre des signaux lumineux, et une ou plusieurs photodiodes configurées pour recevoir et mesurer des signaux émis par les LED. Le document EP 3 780 123 A1 divulgue par exemple un procédé de fabrication de dispositifs optoélectroniques comportant chacun une pluralité de diodes semiconductrices, par exemple au nitrure de gallium, et un circuit électronique de contrôle de ces diodes.

Il serait souhaitable de pouvoir améliorer au moins en partie certains aspects de ces systèmes.

Il serait en particulier souhaitable de pouvoir réaliser simultanément, au moyen d'une étape d'épitaxie commune, un empilement actif d'émission de la LED et un empilement actif de réception de la photodiode.

### Résumé de l'invention

Pour cela, un mode de réalisation prévoit un procédé de fabrication d'un dispositif optoélectronique comportant au moins une LED et au moins une photodiode, comprenant les étapes successives suivantes :
a) former, par épitaxie, un empilement actif semiconducteur d'émission et de réception commun à la LED et à la photodiode ;
b) former des tranchées s'étendant verticalement à travers l'empilement actif et délimitant latéralement la LED et la photodiode,
dans lequel les tranchées sont agencées de façon que les dimensions latérales de la LED soient inférieures aux dimensions latérales de la photodiode.

Selon un mode de réalisation, les tranchées sont agencées de façon que les dimensions latérales de la LED soient au moins deux fois inférieures aux dimensions latérales de la photodiode.

Selon un mode de réalisation, les tranchées sont agencées de façon que les dimensions latérales de la LED soient au moins quatre fois inférieures aux dimensions latérales de la photodiode.

Selon un mode de réalisation, les tranchées sont agencées de façon que les dimensions latérales de la LED soient inférieures à 4 µm.

Selon un mode de réalisation, le procédé comprend, entre l'étape a) et l'étape b), une étape de report et de fixation de l'empilement actif sur une face d'un circuit intégré de contrôle préalablement formé dans et sur un substrat semiconducteur.

Selon un mode de réalisation, à l'étape de report et de fixation, l'empilement actif est fixé sur ladite face du circuit intégré de contrôle par collage moléculaire.

Selon un mode de réalisation, à l'issue de l'étape de report et de fixation, l'empilement actif s'étend de façon continue sur toute la surface du circuit intégré de contrôle.

Selon un mode de réalisation, l'empilement actif semiconducteur comprend un ou plusieurs alliages semiconducteurs de type III-V ou II-VI.

Un autre mode de réalisation prévoit un dispositif optoélectronique comportant au moins une LED et au moins une photodiode comprenant chacune un empilement actif semiconducteur d'émission et de réception de même nature et de même composition, dans lequel les dimensions latérales de la LED sont inférieures aux dimensions latérales de la photodiode.

Selon un mode de réalisation, le dispositif comprend en outre un circuit intégré de contrôle sur une face duquel sont fixées la LED et la photodiode, le circuit intégré de contrôle étant adapté à piloter la LED avec une densité de courant plus élevée que celle de la photodiode.

Selon un mode de réalisation, le circuit intégré de contrôle est adapté à piloter la LED avec une densité de courant au moins dix fois plus élevée que celle de la photodiode.

Un autre mode de réalisation prévoit un procédé de fabrication d'un dispositif optoélectronique comportant au moins une LED et au moins une photodiode, comprenant les étapes suivantes :
a) former un empilement semiconducteur de support comprenant au moins une couche semiconductrice dopée ;
b) former simultanément, lors d'une étape d'épitaxie commune, un empilement actif semiconducteur d'émission de la LED et un empilement actif semiconducteur de réception de la photodiode ;
c) former des tranchées s'étendant verticalement à travers l'empilement de support et délimitant latéralement au moins un premier plot de support et au moins un deuxième plot de support,

dans lequel, à l'issue des étapes b) et c), l'empilement actif semiconducteur d'émission de la LED recouvre le premier plot de support et l'empilement actif de réception de la photodiode recouvre le deuxième plot de support,
le procédé comprenant en outre, après l'étape c), une étape d) de porosification de ladite couche semiconductrice dopée dans le premier plot de support sans porosifier ladite couche semiconductrice dopée dans le deuxième plot de support, ou une étape de porosification de ladite couche semiconductrice dopée dans le deuxième plot de support sans porosifier ladite couche semiconductrice dopée dans le premier plot de support.

Selon un mode de réalisation, l'étape c) de formation des tranchées à travers l'empilement de support et l'étape d) de porosification de la couche semiconductrice dopée sont mises en oeuvre avant l'étape b) d'épitaxie de l'empilement actif semiconducteur d'émission de la LED et de l'empilement actif semiconducteur de réception de la photodiode, et, lors de l'étape d), ladite couche semiconductrice dopée est porosifiée dans le deuxième plot de support et n'est pas porosifiée dans le premier plot de support.

Selon un mode de réalisation, l'étape c) de formation des tranchées à travers l'empilement de support est mise en oeuvre après l'étape b) d'épitaxie de l'empilement actif semiconducteur d'émission de la LED et de l'empilement actif semiconducteur de réception de la photodiode, et, lors de l'étape d), ladite couche semiconductrice dopée est porosifiée dans le premier plot de support et non dans le deuxième plot de support.

Selon un mode de réalisation, à l'étape d), les flancs de la couche semiconductrice dopée dans le deuxième plot sont mis en contact avec l'électrolyte, tandis que les flancs de la couche semiconductrice dopée dans le premier plot sont protégés du contact avec l'électrolyte par une couche de protection.

Selon un mode de réalisation, à l'étape d), les flancs de la couche semiconductrice dopée dans le premier plot sont mis en contact avec un électrolyte, tandis que les flancs de la couche semiconductrice dopée dans le deuxième plot sont protégés du contact avec l'électrolyte par une couche de protection.

Selon un mode de réalisation, à l'étape d), un courant de polarisation est appliqué à travers ladite couche semiconductrice dopée.

Selon un mode de réalisation, le procédé comprend, après les étapes b) et d), une étape de report et de fixation de la LED et de la photodiode sur une face d'un circuit intégré de contrôle préalablement formé dans et sur un substrat semiconducteur.

Selon un mode de réalisation, lors de l'étape de report et de fixation, la LED et la photodiode sont fixées sur la face du circuit intégré de contrôle par collage moléculaire.

Selon un mode de réalisation, les tranchées sont agencées de façon que les dimensions latérales de la LED soient inférieures aux dimensions latérales de la photodiode.

Selon un mode de réalisation, l'empilement actif semiconducteur d'émission de la LED et l'empilement actif semiconducteur de réception de la photodiode comprennent un ou plusieurs alliages semiconducteurs de type III-V ou II-VI.

Un autre mode de réalisation prévoit un dispositif optoélectronique comportant au moins une LED comprenant un empilement actif semiconducteur d'émission et au moins une photodiode comprenant un empilement actif semiconducteur de réception, le dispositif comprenant en outre une couche semiconductrice dopée en vis à vis de la LED et de la photodiode, dans lequel la couche semiconductrice dopée est poreuse en vis à vis de la LED et non poreuse en vis à vis de la photodiode, ou dans lequel la couche semiconductrice dopée est poreuse en vis à vis de la photodiode et non poreuse en vis à vis de la LED.

Selon un mode de réalisation, le dispositif comprend en outre un circuit intégré de contrôle sur une face duquel sont fixées la LED et la photodiode, le circuit intégré de contrôle étant adapté à piloter la LED avec une densité de courant plus élevée que celle de la photodiode.

Selon un mode de réalisation, le circuit intégré de contrôle est adapté à piloter la LED avec une densité de courant au moins dix fois plus élevée que celle de la photodiode.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C et la figure 1D sont des vues en coupe illustrant des étapes d'un exemple de mise en oeuvre d'un procédé de fabrication d'un dispositif optoélectronique selon un premier mode de réalisation ;
la figure 2A, la figure 2B, la figure 2C, la figure 2D, la figure 2E et la figure 2F sont des vues en coupe illustrant des étapes d'un exemple de mise en oeuvre d'un procédé de fabrication d'un dispositif optoélectronique selon un deuxième mode de réalisation ;
la figure 3A, la figure 3B, la figure 3C, la figure 3D et la figure 3E sont des vues en coupe illustrant des étapes d'un exemple de mise en oeuvre d'un procédé de fabrication d'un dispositif optoélectronique selon un troisième mode de réalisation ; et
la figure 4 est un diagramme illustrant la réponse d'un empilement actif d'émission de LED et d'un empilement actif de réception de photodiode réalisés au moyen d'une étape d'épitaxie commune.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des connexions électriques et des circuits de contrôle des LED et des photodiodes des dispositifs décrits n'a pas été détaillée, les modes de réalisation décrits étant compatibles avec les réalisations usuelles de ces éléments ou la réalisation de ces éléments étant à la portée de la personne du métier à partir des indications de la présente description. En outre, les applications susceptibles de tirer avantage des modes de réalisation décrits n'ont pas été détaillées, les modes de réalisation décrits pouvant avantageusement être utilisés pour toute application comportant une ou plusieurs LED et une ou plusieurs photodiodes destinées à fonctionner dans une même gamme de longueurs d'ondes, par exemple une gamme de longueur d'ondes de lumière visible, ultraviolette ou proche infrarouge.

Sauf précision contraire, lorsque l'on fait référence à deux éléments électriquement connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Selon un aspect des modes de réalisation décrits, on prévoit un procédé de fabrication d'un dispositif optoélectronique dans lequel on réalise simultanément, lors d'une même étape d'épitaxie, un empilement actif émissif de LED et un empilement actif photosensible de photodiode.

Un avantage réside dans la réduction de coût par rapport à des procédés comprenant des étapes d'épitaxie spécifiques distinctes pour réaliser successivement l'empilement actif émissif de LED et l'empilement actif photosensible de photodiode.

La LED et la photodiode peuvent être intégrés de façon monolithique dans une même puce optoélectronique, ou être séparés par découpe en fin de procédé pour être intégrés dans des puces distinctes, par exemple destinées à être assemblées au sein d'un même dispositif optoélectronique.

L'empilement actif émissif de LED et l'empilement actif photosensible de photodiode sont par exemple des empilements semiconducteurs inorganiques, par exemple à base de matériaux semiconducteurs de type III-V, par exemple à base de nitrures du groupe III, par exemple de gallium, d'aluminium, d'indium ou d'un alliage à base d'un ou plusieurs de ces matériaux. A titre de variante, l'empilement actif émissif de LED et l'empilement actif photosensible de photodiode sont à base de matériaux semiconducteurs de type II-VI, par exemple ZnCdSe (zinc-cadmium-sélénium).

Un même empilement actif à base de nitrure de gallium peut par exemple être utilisé en émission comme empilement actif de LED, ou en réception, comme empilement actif de photodiode. La photodiode présente alors avantageusement un courant d'obscurité très faible et une bande passante optique en réception étroite ce qui permet d'obtenir un très bon rapport signal sur bruit.

Toutefois, une difficulté réside alors dans le fait que la longueur d'onde optimale d'émission de la LED (pic d'émission) est décalée vers le haut de quelques dizaines de nanomètres, typiquement de l'ordre de 20 nm pour un empilement actif à base de nitrure de gallium (GaN), par exemple à base de nitrure d'indium-gallium (InGaN), par rapport à la longueur d'onde optimale de réception de la photodiode (pic d'absorption). Il s'agit du décalage de Stokes (Stokes shift en anglais), qui provient notamment de l'énergie de liaison des paires électron-trou. Ceci affecte la sensibilité de la photodiode dans la gamme de longueurs d'ondes d'émission de la LED, et par conséquent l'efficacité du système LED-photodiode.

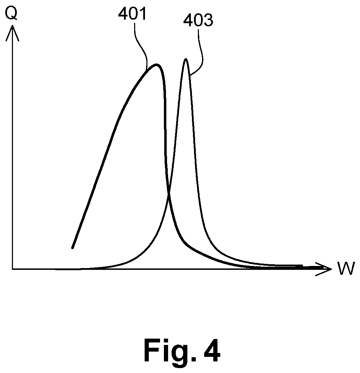

Ce phénomène est notamment illustré par la figure 4.

La figure 4 est un diagramme représentant l'évolution, en fonction de la longueur d'onde W (en abscisse), de l'efficacité quantique Q en réception (courbe 401) et en émission (courbe 403) d'un empilement actif de diode à base de nitrure de gallium (GaN), par exemple à base de nitrure d'indium-gallium (InGaN).

Selon un aspect d'un premier mode de réalisation, on prévoit de former, par épitaxie, un empilement actif semiconducteur commun à la LED et à la photodiode, puis de former des tranchées s'étendant verticalement à travers l'empilement actif et délimitant latéralement la LED et la photodiode. Selon le premier mode de réalisation, la LED présente des dimensions latérales inférieures à celles de la photodiode. Ceci permet de relâcher les contraintes mécaniques dans l'empilement actif de LED plus fortement que dans l'empilement actif de photodiode. Il en résulte une diminution du champ électrique interne dans l'empilement actif de LED par rapport au champ électrique interne dans l'empilement actif de photodiode. Cette diminution du champ électrique interne dans l'empilement actif de LED conduit à décaler vers le bas (on parle de décalage vers le bleu ou blue-shift en anglais) le pic d'émission de la LED. Ceci permet de compenser au moins partiellement le décalage de Stokes entre le pic d'émission et le pic d'absorption de l'empilement actif. Ainsi, le pic d'émission de la LED se rapproche du pic d'absorption de la photodiode, ce qui améliore l'efficacité du système.

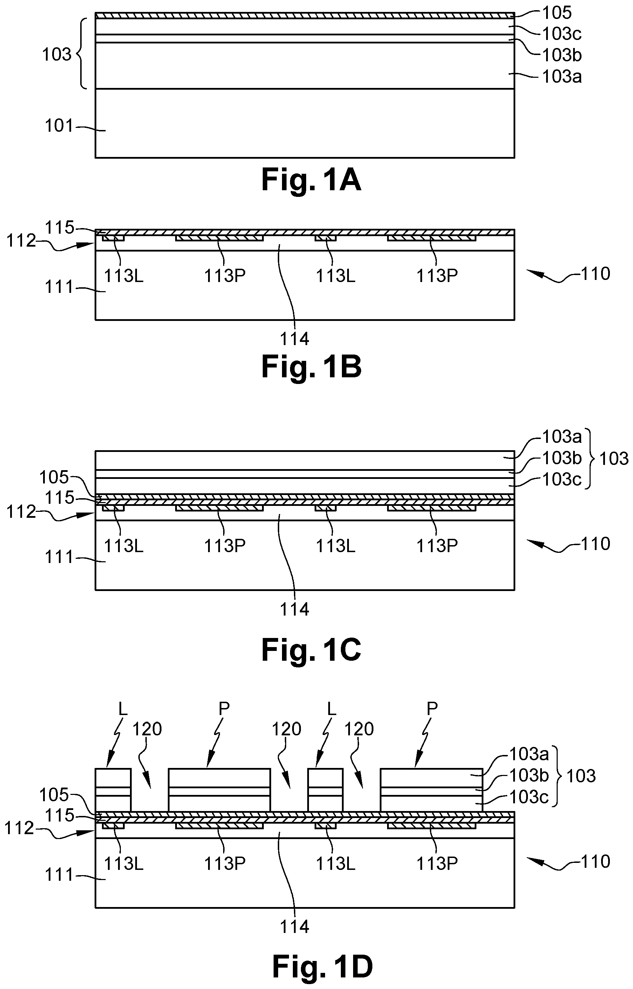

Les figures 1A à 1D sont des vues en coupe illustrant schématiquement des étapes d'un exemple de mise en oeuvre d'un procédé de fabrication d'un dispositif optoélectronique selon le premier mode de réalisation.

La figure 1A illustre une structure comportant un empilement actif semiconducteur d'émission et de réception 103 disposé sur la face supérieure d'un substrat de support 101.

L'empilement actif 103 comprend par exemple une couche semiconductrice 103a dopée d'un premier type de conductivité, par exemple de type N, revêtant la face supérieure du substrat 101, une couche active 103b revêtant la face de la couche 103a opposée au substrat 101, c'est à dire sa face supérieure dans l'orientation de la figure 1A, et une couche semiconductrice 103c dopée d'un second type de conductivité, par exemple de type P, revêtant la face de la couche 103b opposée à la couche 103a, c'est à dire sa face supérieure dans l'orientation de la figure 1A. A titre d'exemple, la couche 103b est en contact, par sa face inférieure, avec la face supérieure de la couche 103a, et, par sa face supérieure, avec la face inférieure de la couche 103c.

Les couches 103a, 103b et 103c de l'empilement actif 103 s'étendent par exemple chacune de façon continue et avec une épaisseur sensiblement uniforme sur toute la surface du substrat 101.

Les couches 103a, 103b et 103c sont par exemple formées successivement par épitaxie sur la face supérieure du substrat de support 101.

A titre d'exemple, le substrat de support 101 est en saphir ou en silicium. Les couches semiconductrices 103a et 103c de l'empilement actif 103 sont par exemple en nitrure de gallium. La couche active 103b comprend par exemple un empilement de couches formant chacune un puits quantique, par exemple à base de nitrure d'indium-gallium (InGaN).

Une couche tampon, non représentée, peut faire interface entre la face supérieure du substrat 101 et la face inférieure de la couche inférieure 103a.

La figure 1A illustre en outre une étape de dépôt, sur la face supérieure de l'empilement actif 103, d'une couche métallique 105. Dans l'exemple représenté, la couche 105 s'étend de façon continue et avec une épaisseur sensiblement uniforme sur toute la surface supérieure de l'empilement actif 103. A titre d'exemple, la couche 105 est en contact, par sa face inférieure, avec la face supérieure de la couche supérieure 103c de l'empilement actif.

La figure 1B représente de façon schématique un circuit intégré de contrôle 110, préalablement formé dans et sur un substrat semiconducteur 111, par exemple un substrat en silicium. Dans cet exemple, le circuit de contrôle 110 comprend, du côté de sa face supérieure, pour chacune des LED du dispositif, un plot métallique de connexion 113L destiné à être connecté à l'une des électrodes (anode ou cathode) de la LED, de façon à pouvoir commander un courant circulant dans la LED et/ou appliquer une tension aux bornes de la LED. Le circuit de contrôle 110 comprend en outre dans cet exemple, du côté de sa face supérieure, pour chacune des photodiodes du dispositif, un plot métallique de connexion 113P destiné à être connecté à l'une des électrodes (anode ou cathode) de la photodiode, de façon à pouvoir lire un signal électrique représentatif de l'intensité d'un rayonnement lumineux reçu par la photodiode dans sa gamme de longueurs d'ondes de sensibilité.

Le circuit de contrôle comprend par exemple, pour chaque LED, connectée au plot métallique 113L dédié à la LED, une cellule élémentaire de contrôle comportant un ou plusieurs transistors, permettant de contrôler le courant circulant dans la LED et/ou une tension appliquée aux bornes de la LED, et, pour chaque photodiode, connecté au plot métallique 113P dédié à la photodiode, une cellule élémentaire de lecture comportant un ou plusieurs transistors, permettant de lire un signal électrique représentatif de l'intensité d'un rayonnement lumineux reçu par la photodiode dans sa gamme de longueurs d'ondes de sensibilité. Le circuit de lecture comprend par exemple un amplificateur transimpédance utilisé pour amplifier le courant de la photodiode.

Le circuit de contrôle 110 est par exemple réalisé en technologie CMOS. Les plots métalliques 113L, 113P peuvent être latéralement entourés par un matériau isolant 114, par exemple de l'oxyde de silicium, de façon que le circuit de contrôle 110 présente une surface supérieure sensiblement plane comprenant une alternance de régions métalliques 113 et de régions isolantes 114. Le contact sur les électrodes des LED ou des photodiodes non connectées aux plots 113L, 113P, peut être pris de façon collective, par exemple dans une région périphérique du circuit de contrôle 110, par l'intermédiaire d'un ou plusieurs plots de connexion (non visibles sur la figure) du circuit de contrôle 110. A titre d'exemple, le circuit de contrôle 110 comprend, du côté de la face supérieure du substrat 111, un empilement de niveaux isolants et conducteurs formant un réseau d'interconnexion 112 comprenant notamment les plots de connexion 113L, 113P, la face supérieure du réseau d'interconnexion 112 définissant la face supérieure du circuit 110.

La figure 1B illustre en outre une étape de dépôt, sur la face supérieure du circuit intégré de contrôle 110, d'une couche métallique 115. Dans l'exemple représenté, la couche 115 s'étend de façon continue et avec une épaisseur sensiblement uniforme sur toute la surface supérieure du circuit 110. A titre d'exemple, la couche 115 est en contact, par sa face inférieure, avec la face supérieure du réseau d'interconnexion 112 du circuit de contrôle 110.

La couche 115 est par exemple en le même matériau que la couche 105. A titre d'exemple, les couches 105 et 115 comprennent chacune une couche supérieure dite couche de collage. Les couches de collage des couches 105 et 115 sont de préférence en un même matériau, par exemple en titane.

La figure 1C illustre la structure obtenue à l'issue d'une étape de report de l'empilement actif de LED et de photodiode 103 sur la face supérieure du circuit de contrôle 110. Pour cela, la structure de la figure 1A peut être retournée, puis rapportée sur la structure de la figure 1B de façon à mettre en contact la face de la couche métallique 105 opposée au substrat 101 (c'est à dire sa face inférieure dans l'orientation de la figure 1C, correspondant à sa face supérieure dans l'orientation de la figure 1A) avec la face de la couche métallique 115 opposée au substrat 111 (c'est à dire sa face supérieure dans l'orientation des figures 1B et 1C). Au cours de cette étape, l'empilement actif 103 est fixé (bonded) au circuit de contrôle 110. A titre d'exemple, la fixation de l'empilement actif 103 sur le circuit de contrôle 110 peut être obtenue par collage moléculaire entre les deux surfaces mises en contact. A titre de variante, la fixation des deux surfaces peut être réalisée par thermocompression, collage eutectique, ou par toute autre méthode de fixation adaptée.

Une fois le collage réalisé, le substrat de support 101 est retiré de façon à découvrir la face supérieure (dans l'orientation de la figure 1C) de la couche semiconductrice 103c de l'empilement actif 103. Le substrat 101 est par exemple retiré par meulage et/ou gravure à partir de sa face opposée à l'empilement actif 103. A titre de variante, dans le cas d'un substrat 101 transparent, par exemple un substrat en saphir, le substrat 101 peut être détaché de l'empilement actif 103 au moyen d'un faisceau laser projeté à travers le substrat 101 depuis sa face opposée à l'empilement actif 103 (procédé de type laser lift-off). Plus généralement, toute autre méthode permettant de retirer le substrat 101 peut être utilisée. Après le retrait du substrat, une étape supplémentaire de gravure peut être prévue pour retirer d'éventuelles couches tampon subsistant du côté de la face supérieure de la couche semiconductrice 103c. En outre, une partie de l'épaisseur de la couche 103c peut être retirée, par exemple par gravure. A l'issue de cette étape, l'empilement actif 103 revêt sensiblement toute la surface du circuit de contrôle 110, sans discontinuité. A titre d'exemple, l'épaisseur de l'empilement actif 103 à l'issue de l'étape de la figure 1D est comprise entre 0,5 et 2 µm.

A l'issue de cette étape, les contraintes mécaniques de l'empilement actif épitaxié 103 sont partiellement transférées dans le substrat 111 du circuit de commande 110.

La figure 1D illustre une étape postérieure à l'étape de la figure 1C, au cours de laquelle des tranchées 120 sont formées dans l'empilement actif 103, depuis sa face supérieure, par exemple par lithographie puis gravure, de façon à délimiter une ou plusieurs LED L et une ou plusieurs photodiodes P, correspondant chacune à une portion de l'empilement actif 103 en forme d'îlot ou mésa. Dans l'exemple représenté, les tranchées 120 s'étendent verticalement sur toute la hauteur de l'empilement actif 103 et débouchent sur la face supérieure de la couche métallique 105. Les tranchées 120 peuvent être alignées sur des repères préalablement formés sur le circuit de contrôle 110. Dans l'exemple représenté, chaque LED L est située, en projection verticale, en regard d'un unique plot métallique 113L du circuit de contrôle 110, et chaque photodiode P est située, en projection verticale, en regard d'un unique plot métallique 113P du circuit de contrôle 110. A titre d'exemple, chaque LED L et chaque photodiode P a, en vue de dessus, une forme sensiblement carrée ou rectangulaire. Les tranchées 120 forment par exemple, en vue de dessus, une grille ou un quadrillage séparant latéralement les unes des autres les LED L et les photodiodes P du dispositif.

Les tranchées peuvent ensuite être prolongées à travers les couches métalliques 105 et 115 pour individualiser les connexions électriques sur la couche semiconductrice inférieure 103c de l'empilement actif 103 de chaque LED L et de chaque photodiode P. Des étapes ultérieures peuvent ensuite être mises en oeuvre pour reprendre un contact électrique individuel ou commun sur la couche semiconductrice supérieure 103a de l'empilement actif 103 de chaque LED L et de chaque photodiode P. Ces étapes n'ont pas été détaillées et sont à la portée de la personne du métier à partir des indications de la présente description. A titre d'exemple, ces étapes sont similaires à ce qui a été décrit dans la demande de brevet WO2017194845 ou dans la demande de brevet WO2019092357 précédemment déposées par le demandeur.

Lors de l'étape de la figure 1D de gravure de l'empilement actif 103, une relaxation additionnelle des contraintes mécaniques présentes dans l'empilement actif épitaxié 103 se produit par les bords des îlots ou mésas gravés. Cette relaxation dépend de la taille des îlots ou mésas. En particulier, des îlots ou mésas de petites dimensions présentent une relaxation importante des contraintes, tandis que des îlots ou mésas de dimensions plus importantes conservent une contrainte mécanique relativement élevée. La relaxation peut en outre dépendre de la nature du substrat, qui peut par exemple comprendre un empilement d'une couche de nitrure de gallium sur une couche de silicium, ou un empilement d'une couche de nitrure de gallium sur une couche de saphir, ou un empilement d'une couche de nitrure de gallium poreux sur une couche de silicium.

Selon un aspect du premier mode de réalisation, on prévoit de définir :
- des LED L de dimensions latérales relativement faibles de façon à obtenir une relaxation importante des contraintes mécaniques dans l'empilement actif 103 et par conséquent un décalage vers le bas du pic d'émission relativement important, et
- des photodiodes P de dimensions latérales relativement élevées de façon à obtenir une relaxation moins importante des contraintes mécaniques dans l'empilement actif 103 et par conséquent un décalage vers le bas du pic d'absorption relativement faible.

Ceci permet de compenser au moins partiellement le décalage de Stokes naturellement présent entre le pic d'émission et le pic d'absorption de l'empilement actif 103.

A titre d'exemple, les îlots ou mésa formant les LED L présentent des dimensions latérales inférieures ou égales à 5 µm, par exemple inférieures ou égales à 4 µm, par exemple inférieures ou égales à 2 µm. Ceci permet d'obtenir une relaxation quasi-totale de l'empilement actif lors de la gravure de la LED. Les îlots ou mésa formant les photodiodes P présentent quant à eux des dimensions latérales supérieures à celles des LED, par exemple au moins deux fois supérieures à celles des LED, par exemple au moins quatre fois supérieures à celles des LED, de façon à conserver des contraintes mécaniques relativement élevées dans l'empilement actif 103 des photodiodes P.

A titre d'exemple, non limitatif, pour un empilement actif à base de GaN et pour des LED L carrées d'environ 1 µm de côté et des photodiodes P de 8 à 10 µm de côté, on observe un alignement du pic d'émission des LED L sur le pic d'absorption des photodiodes P.

Les modes de réalisation décrits ne se limitent pas à l'exemple d'agencement des LED L et des photodiodes P représenté sur la figure 1D. A titre d'exemple, le dispositif peut comprendre, sur une première partie de la surface du circuit intégré de contrôle 110, une pluralité de LED L, par exemple identiques (aux dispersions de fabrication près), par exemple agencées en matrice selon des rangées et des colonnes, par exemple avec un pas inter-LED constant. Le dispositif peut en outre comprendre, sur une deuxième partie de la surface du circuit intégré de contrôle 110, une pluralité de photodiodes P, par exemple identiques (aux dispersions de fabrication près), par exemple agencées en matrice selon des rangées et des colonnes, par exemple avec un pas inter-photodiodes constant. Le pas inter-LED dans la première région est par exemple identique au pas inter-photodiodes dans la deuxième région. Les dimensions latérales des LED de la première région sont en revanche inférieures aux dimensions latérales des photodiodes de la deuxième région.

Outre la taille différenciée des LED L par rapport aux photodiodes P, un autre paramètre permettant de réduire le décalage en longueur d'onde entre le pic d'émission des LED et le pic d'absorption des photodiodes est la densité de porteurs de charges dans l'empilement actif et notamment dans les puits quantiques de la couche active 103b. Plus particulièrement, une densité de porteurs élevée conduira à écranter le champ électrique présent dans l'empilement actif, et par conséquent à décaler vers le bas la longueur d'onde de fonctionnement optimale de l'empilement actif.

Ainsi, de façon avantageuse, le circuit de contrôle 110 est configuré pour piloter les LED L à des tensions plus élevées que les photodiodes P. Ceci permet d'obtenir une densité de porteurs plus élevée dans les LED L que dans les photodiodes P, et par conséquent de réduire le décalage entre le pic d'émission des LED L et le pic d'absorption des photodiodes P. A titre d'exemple, les tensions de pilotage sont choisies de façon à avoir une densité de porteurs dans les LED L au moins deux fois plus importante, par exemple au moins cinq fois plus importante, par exemple de l'ordre de dix fois plus importante, que dans les photodiodes P.

La valeur du décalage en longueur d'onde liée à l'augmentation de la densité de courant dans la LED dépend de la structure de l'empilement actif, et notamment de la largeur des puits quantiques de la couche active 103b. En particulier, plus les puits seront larges, plus l'écrantage du champ électrique lié à l'augmentation de la densité de porteurs sera importante, et par conséquent plus le décalage vers le bas de la longueur d'onde d'émission optimale de la LED lié à l'augmentation de la densité de porteurs sera important. L'augmentation de la largeur des puits entraine en revanche un temps de recombinaison radiative plus élevé, ce qui peut être dommageable pour des applications de communication nécessitant un temps de recombinaison court. La personne du métier saura choisir le compromis adapté en fonction des besoins de l'application. A titre d'exemple illustratif, non limitatif, pour une LED comportant des puits quantiques en InGaN de 4 nm d'épaisseur avec un taux d'indium de 14,3%, piloter la LED avec une densité de courant de l'ordre de 100 A/cm² conduit à un décalage vers le bleu du pic d'émission d'environ 6 nm par rapport à un pilotage de la même LED à une densité de courant de l'ordre de 10 A/cm².

Afin de compenser entièrement le décalage de Stokes, on pourra par exemple prévoir de combiner l'effet de relaxation mécanique décrit ci-dessus en prévoyant des LED plus petites que les photodiodes, et l'effet d'écrantage du champ par les porteurs en prévoyant une densité de courant plus importante dans les LED que dans les photodiodes. A titre d'exemple illustratif, non limitatif, pour des LED à base de nitrure de gallium comportant des puits quantiques en InGaN on observe un décalage en longueur d'onde du pic d'émission entre une LED de 4 µm de largeur pilotée à une densité de courant de l'ordre de 200 A/cm² et une LED de même nature de 25 µm de largeur pilotée à une densité de courant de l'ordre de 10 A/cm², de l'ordre de 30 nm. Sur ces 30 nm de décalage, environ 20 nm sont liés à la différence de taille, le reste (environ 10 nm) étant lié à la différence de densité de courant. Ce décalage est typiquement du même ordre que le décalage de Stokes entre l'émission et la réception dans l'empilement actif.

On notera que la compensation par différentiation des densités de porteurs entre les LED et les photodiodes peut aussi être obtenue dans un dispositif ayant des LED L de mêmes dimensions latérales que les photodiodes P, voire des dimensions latérales supérieures à celles des photodiodes P.

Selon un aspect d'un deuxième mode de réalisation, on prévoit, avant l'étape d'épitaxie commune au cours de laquelle sont formés simultanément les empilements actifs d'émission et de réception, de porosifier localement, en vis à vis des photodiodes du dispositif, une couche support en un matériau semiconducteur, sur laquelle est destiné à être épitaxié l'empilement actif. Il en résulte une relaxation des contraintes mécaniques dans l'empilement actif des photodiodes pendant l'épitaxie, notamment lors de la formation de la couche active 103b de l'empilement. Cette relaxation conduit à une différence de proportions des espèces de l'alliage semiconducteur formant la couche active 103b entre les photodiodes et les LED. En particulier, dans le cas où la couche active comprend des puits quantiques en InGaN, il en résulte une incorporation d'indium plus importante dans les puits quantiques des photodiodes que dans les puits quantiques des LED. Ceci conduit à un décalage vers le rouge, c'est à dire vers le haut, du pic d'absorption des photodiodes, et donc à compenser au moins partiellement le décalage de Stokes entre le pic d'émission et le pic d'absorption de l'empilement actif.

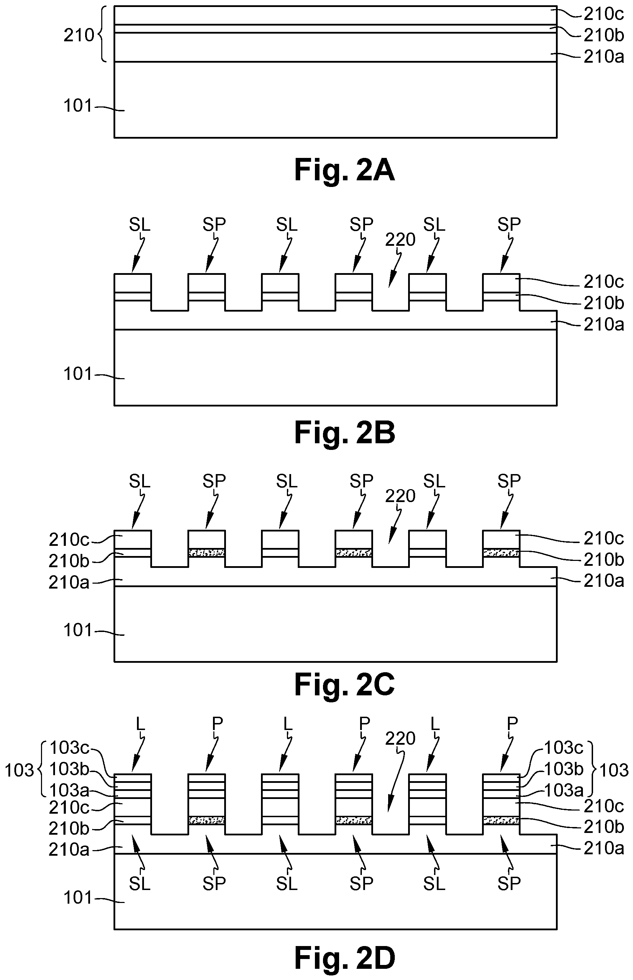

Les figures 2A à 2F sont des vues en coupe illustrant schématiquement des étapes d'un exemple de mise en oeuvre d'un procédé de fabrication d'un dispositif optoélectronique selon le deuxième mode de réalisation.

La figure 2A illustre une structure comportant un empilement semiconducteur de support 210 sur une face d'un substrat de support 101. Le substrat de support 101 est par exemple identique ou similaire à ce qui a été décrit précédemment. L'empilement semiconducteur de support 210 est par exemple en un matériau semiconducteur de type III-V, par exemple en nitrure de gallium. L'empilement semiconducteur de support 210 comprend au moins une couche semiconductrice dopée 210b, de niveau de dopage choisi pour permettre de rendre poreuse la couche 210b lors d'une étape ultérieure de porosification électrolytique. A titre d'exemple, la couche 210b est dopée de type N. A titre d'exemple, la couche 210b est en nitrure de gallium dopé de type N de niveau de dopage compris entre 10¹⁹ et 1,5*10¹⁹ atomes/cm³.

Dans l'exemple représenté, l'empilement de support 210 comprend en outre, du côté de la face inférieure de la couche 210b, par exemple en contact avec la face inférieure de la couche 210b, une couche semiconductrice 210a. La couche 210a est par exemple en le même matériau que la couche 210b mais de niveau de dopage inférieur à celui de la couche 210b, par exemple de niveau de dopage au moins dix fois inférieur, à celui de la couche 210b. A titre de variante, la couche 210a est en un matériau différent du matériau de la couche 210b.

Dans l'exemple représenté, l'empilement de support 210 comprend en outre, du côté de la face supérieure de la couche 210b, par exemple en contact avec la face supérieure de la couche 210b, une couche semiconductrice 210c. La couche 210c est par exemple en le même matériau que la couche 210b mais de niveau de dopage inférieur à celui de la couche 210b, par exemple de niveau de dopage au moins dix fois inférieur, de préférence au moins 100 fois inférieur, à celui de la couche 210b. A titre de variante, la couche 210c est en un matériau différent du matériau de la couche 210b.

Les couches 210a, 210b et 210c de l'empilement de support 210 s'étendent par exemple chacune de façon continue et avec une épaisseur sensiblement uniforme sur toute la surface du substrat 101.

Les couches 210a, 210b et 210c sont par exemple formées successivement par épitaxie sur la face supérieure du substrat de support 101.

A titre d'exemple, le substrat de support 101 est en saphir ou en silicium. Une couche tampon, non représentée, peut éventuellement faire interface entre la face supérieure du substrat 101 et la face inférieure de la couche inférieure 210a de l'empilement de support 210.

La figure 2B illustre une étape de formation de tranchées 220 dans l'empilement de support 210, depuis sa face supérieure, par exemple par lithographie puis gravure, de façon à définir dans l'empilement 210 une pluralité de plots de support SL et SP en forme d'îlots ou mésas. Chaque plot de support SL est destiné à recevoir, sur sa face supérieure, une LED L du dispositif, et chaque plot de support SP est destiné à recevoir, sur sa face supérieure, une photodiode P du dispositif.

Dans l'exemple représenté, les tranchées 220 s'étendent verticalement depuis la face supérieure de l'empilement, traversent entièrement les couches 210c et 210b, et débouchent dans la couche 210a sans la traverser entièrement. A titre de variante, les tranchées 220 traversent entièrement la couche 210.

Les tranchées 220 forment par exemple, en vue de dessus, une grille ou un quadrillage séparant latéralement les uns des autres les plots de support SL et SP destinés à recevoir les LED L et les photodiodes P du dispositif.

Les plots de support SP et SL ont par exemple tous les mêmes dimensions latérales, par exemple comprises entre 1 µm et 25 µm, par exemple entre 2 et 8 µm. A titre d'exemple, les plots de support SP et SL ont, en vue de dessus, une forme carrée ou rectangulaire.

A ce stade, dans chaque plot de support SL et SP, les flancs de la couche semiconductrice dopée 210b de l'empilement de support sont exposés.

La figure 2C illustre la structure obtenue à l'issue d'une étape de porosification sélective de la couche 210b, localisée uniquement dans les plots de support SP des photodiodes P du dispositif. Lors de cette étape, la couche 210b des plots de support SP est rendue poreuse par gravure électrolytique ou électroporosification. La couche 210b des plots de support SL reste en revanche non poreuse.

Pour cela, les flancs des plots de support peuvent être préalablement revêtus d'une couche de protection (non visible sur la figure), par exemple en un matériau isolant, par exemple en oxyde ou en nitrure de silicium. La couche de protection est par exemple initialement déposée sur toute la face supérieure, puis retirée localement, par exemple par photolithographie et gravure, de manière à exposer les flancs des plots de support SP sans exposer les flancs des plots de support SL.

La structure peut ensuite être plongée dans un bain électrolytique (non visible sur la figure), par exemple une solution à base d'acide oxalique, par exemple une solution aqueuse d'acide oxalique.

Une tension de polarisation est ensuite appliquée de façon à faire circuler un courant dans la couche semiconductrice dopée 210b. A titre d'exemple, la tension est appliquée entre une première électrode (non visible sur la figure) connectée à la couche 210a et l'électrolyte (non visible sur la figure) connecté par la tranche à la couche 210c.

Sous l'effet du courant de polarisation, les portions de la couche 210b en contact, par leurs flancs, avec l'électrolyte, c'est à dire les portions de la couche 210b comprises dans les plots de support SP des photodiodes P du dispositif, deviennent poreuses. Les portions de la couche 210b protégées du contact avec l'électrolyte, c'est à dire les portions de la couche 210b comprises dans les plots de support SL des LED L du dispositif, restent en revanche intactes (non poreuses).

On notera que, dans cet exemple, les niveaux de dopage des couches 210a, 210b et 210c de l'empilement de support sont choisis de façon que seule la couche 210b soit rendue poreuse lors de l'étape d'électroporosification.

A l'issue de cette étape, la couche de protection revêtant les flancs des plots de support SL peut être retirée.

La figure 2D illustre la structure obtenue à l'issue d'une étape d'épitaxie commune au cours de laquelle est formé, sur chaque plot de support SL et sur chaque plot de support SP, un empilement actif semiconducteur 103. L'épitaxie est par exemple localisée dans des ouvertures préalablement gravées dans une couche diélectrique, non représentée.

Sur chaque plot de support SL et SP, l'empilement actif 103 recouvre par exemple toute la surface supérieure du plot. La portion de l'empilement actif 103 revêtant chaque plot SL définit une LED du dispositif. La portion de l'empilement actif 103 revêtant chaque plot SP définit une photodiode du dispositif.

Sur chaque plot de support SP et SL, l'empilement actif 103 comprend, dans l'ordre à partir de la surface supérieure du plot, une couche semiconductrice 103a, une couche semiconductrice 103b, et une couche semiconductrice 103c, par exemple identiques ou similaires à ce qui a été décrit précédemment en relation avec les figures 1A à 1D. Les couches 103a, 103b et 103c sont par exemple formées successivement par épitaxie à partir de la face supérieure des plots SP et SL. A titre d'exemple, dans chaque plot SP et SL, la couche semiconductrice inférieure 103a de l'empilement actif 103 est en contact, par sa face inférieure, avec la face supérieure de la couche 210c.

Du fait de la présence de la couche poreuse 210b dans les plots de support SP, on obtient une relaxation mécanique plus importante dans l'empilement actif des photodiodes P que dans l'empilement actif des LED L. Il en résulte, pendant l'épitaxie, une incorporation des espèces différentes dans la couche active 103b de l'empilement actif des LED L et dans la couche active 103b de l'empilement actif des photodiodes P. En particulier, dans le cas d'une couche active 103b à base d'InGaN, il en résulte une incorporation d'indium plus importante dans la couche active 103b des photodiodes P que dans la couche active 103b des LED L. Ainsi, la présence de la couche poreuse 210b dans les plots de support SP des photodiodes P conduit à décaler le pic d'absorption des photodiodes P vers le haut en longueur d'onde (vers le rouge), et ainsi à le rapprocher du pic d'émission des LED L.

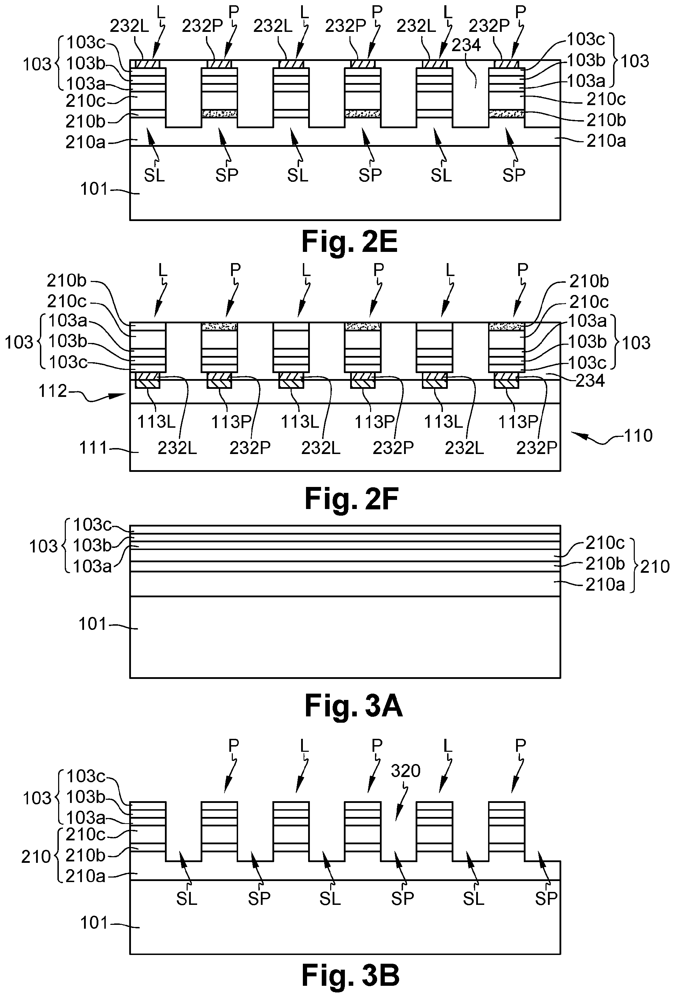

La figure 2E illustre la structure obtenue à l'issue d'une étape de formation, sur chaque LED L, d'une métallisation de contact 232L sur et en contact avec la face supérieure de la couche semiconductrice supérieure 103c de l'empilement actif 103 de la LED, et, sur chaque photodiode P, d'une métallisation de contact 232P sur et en contact avec la face supérieure de la couche semiconductrice supérieure 103c de l'empilement actif 103 de la photodiode.

La figure 2E illustre en outre une étape de remplissage des tranchées 220 et de l'espace entre les LED L et les photodiodes P par un matériau électriquement isolant 234, par exemple de l'oxyde de silicium.

Après le remplissage, une étape de planarisation peut être mise en oeuvre, par exemple par polissage mécano-chimique (CMP), de façon que les métallisations de contact 232L, 232P affleurent au niveau de la face supérieure du matériau de remplissage 234.

La figure 2F illustre une étape de report et de fixation de la structure de la figure 2E sur un circuit intégré de contrôle 110, par exemple similaire à celui de la figure 1B.

Lors de cette étape, les métallisations de contact 232L, 232P de la structure de la figure 2E sont mises en contact, par leur face opposée au substrat de support 101, avec la face des métallisations de contact 113L, 113P du circuit de contrôle 110 opposée au substrat 111.

A titre d'exemple, la structure de la figure 2E est fixée et connectée électriquement au circuit intégré de contrôle 110 par collage moléculaire, par exemple par collage hybride métal-métal / oxyde-oxyde.

Après assemblage des deux structures, le substrat de support 101 de la structure de la figure 2E peut être retiré. En outre, tout ou partie de l'empilement semiconducteur de support 210 peut être retiré, par exemple par meulage ou gravure.

Dans l'exemple représenté, la couche 210a de l'empilement de support 210 est entièrement retirée, et les couches 210b et 210c sont conservées. Les modes de réalisation décrits ne se limitent toutefois pas à cet exemple.

Des étapes ultérieures peuvent ensuite être mises en oeuvre pour reprendre un contact électrique individuel ou commun sur la couche semiconductrice supérieure 103a de l'empilement actif 103 de chaque LED L et de chaque photodiode P. Par exemple, une couche d'un matériau électriquement conducteur transparent, par exemple un oxyde conducteur transparent, par exemple de l'oxyde d'indium-étain (ITO) est déposée sur et en contact avec la face supérieure de la structure de la figure 2F. Ces étapes n'ont pas été détaillées et sont à la portée de la personne du métier à partir des indications de la présente description.

De façon similaire à ce qui a été décrit précédemment, le circuit de contrôle peut optionnellement être configuré pour piloter les LED et les photodiodes avec des densités de porteur adaptées à réduire le décalage entre le pic d'émission des LED et le pic d'absorption des photodiodes.

Selon un aspect d'un troisième deuxième mode de réalisation, on prévoit de former des plots de support SP et SL de façon similaire à ce qui a été décrit ci-dessus en relation avec les figures 2A à 2F, mais de porosifier sélectivement la couche 210b des plots de support seulement après l'étape d'épitaxie commune au cours de laquelle sont formés simultanément les empilements actifs 103 des LED L et des photodiodes P. Dans ce troisième mode de réalisation, la couche 210b est rendue poreuse à l'aplomb des LED L et est conservée intacte (non poreuse) à l'aplomb des photodiodes P. Ceci conduit à relaxer au moins partiellement les contraintes mécaniques dans l'empilement actif des LED L sans appliquer cette relaxation dans les photodiodes P. Il en résulte une diminution du champ électrique interne dans l'empilement actif de LED par rapport au champ électrique interne dans l'empilement actif de photodiode. Cette diminution du champ électrique interne dans l'empilement actif de LED conduit à décaler vers le bas le pic d'émission de la LED. Là encore, ceci permet de compenser au moins partiellement le décalage de Stokes entre le pic d'émission et le pic d'absorption de l'empilement actif. Ainsi, le pic d'émission de la LED se rapproche du pic d'absorption de la photodiode, ce qui améliore l'efficacité du système.

Les figures 3A à 3E sont des vues en coupe illustrant schématiquement des étapes d'un exemple de mise en oeuvre d'un procédé de fabrication d'un dispositif optoélectronique selon le troisième mode de réalisation.

La figure 3A illustre une structure comportant un empilement semiconducteur de support 210 sur une face d'un substrat de support 101. L'empilement de support 210 et le substrat de support 101 sont par exemple identique ou similaire à ce qui a été décrit précédemment en relation avec la figure 2A.

La figure 3A illustre en outre une étape de formation d'un empilement actif 103 de LED et de photodiode sur la face supérieure de l'empilement semiconducteur de support 210. L'empilement actif 103 est par exemple identique ou similaire à ce qui a été décrit précédemment, notamment en relation avec la figure 1A. Les couches 103a, 103b et 103c sont par exemple formées successivement par épitaxie à partir de la face supérieure de l'empilement de support 210. A titre d'exemple, la couche semiconductrice inférieure 103a de l'empilement actif 103 est en contact, par sa face inférieure, avec la face supérieure de la couche 210c.

A ce stade, les couches de l'empilement de support 210 et les couches de l'empilement actif 103 s'étendent chacune de façon continue et avec une épaisseur uniforme sur toute la surface du substrat de support 101.

La figure 3B illustre une étape de formation de tranchées 320 dans l'empilement actif 103 et dans l'empilement de support 210, depuis la face supérieure de l'empilement actif 103, par exemple par lithographie puis gravure, de façon à définir dans l'empilement 210 une pluralité de plots de support SL et SP en forme d'îlots ou mésas, chaque plot de support SL étant revêtu, sur sa face supérieure, par une portion de l'empilement actif 103 définissant une LED L du dispositif, et chaque plot de support SP étant revêtu, sur sa face supérieure, par une portion de l'empilement actif 103 définissant une photodiode P du dispositif.

Dans l'exemple représenté, les tranchées 320 s'étendent verticalement depuis la face supérieure de l'empilement actif 103, traversent entièrement les couches 103c, 103b, 103a, 210c et 210b, et débouchent dans la couche 210a sans la traverser entièrement. A titre de variante, les tranchées 220 traversent entièrement la couche 210.

Les tranchées 320 forment par exemple, en vue de dessus, une grille ou un quadrillage séparant latéralement les LED L et les photodiodes P et les plots de support SL et SP.

Les LED L et les photodiodes P, et les plots de support SP et SL sous-jacents, ont par exemple tous les mêmes dimensions latérales, par exemple comprises entre 1 µm et 25 µm, par exemple entre 2 et 8 µm. A titre d'exemple, les LED L et les photodiodes P et les plots de support SP et SL ont, en vue de dessus, une forme carrée ou rectangulaire. Plus généralement, les LED L et les photodiodes P peuvent avoir une forme quelconque, par exemple ronde ou hexagonale.

A ce stade, dans chaque plot de support SL et SP, les flancs de la couche semiconductrice dopée 210b de l'empilement de support sont exposés.

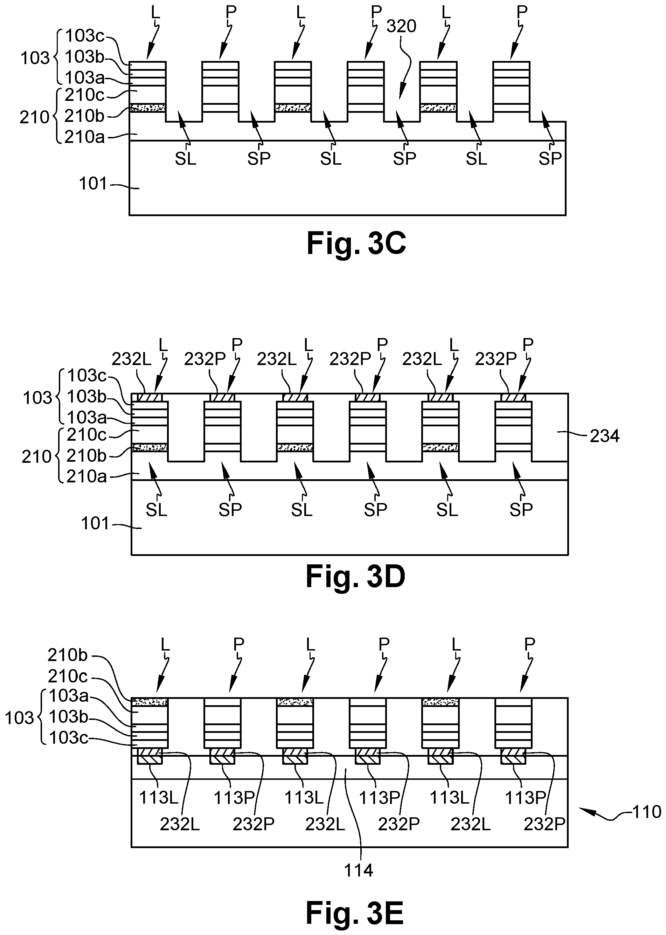

La figure 3C illustre la structure obtenue à l'issue d'une étape de porosification sélective de la couche 210b, localisée uniquement dans les plots de support SL des LED L du dispositif. Cette étape est similaire à ce qui a été décrit précédemment en relation avec la figure 2C, à la différence que, dans l'exemple de la figure 3C, la couche 210b des plots de support SL est rendue poreuse, tandis que la couche 210b des plots de support SP reste intacte (non poreuse).

Pour cela, pendant l'étape d'électroporosification, les flancs des plots de support SP peuvent être protégés du contact avec l'électrolyte par une couche de protection (non visible sur la figure), les flancs des plots de support SL étant en revanche en contact avec l'électrolyte.

Dans l'exemple de la figure 3C, la tension de polarisation permettant de faire circuler un courant dans la couche 210b est par exemple appliquée entre une première électrode (non visible sur la figure) connectée à la couche 210a et l'électrolyte (non visible sur la figure) connecté par la tranche à la couche 103c.

Du fait de la porosification de la couche 210b dans les plots de support SL, on obtient une relaxation mécanique plus importante dans l'empilement actif des LED L que dans l'empilement actif des photodiodes P. Ceci conduit à décaler le pic d'émission des LED vers le bas, et ainsi à le rapprocher du pic d'absorption des photodiodes P.

La figure 3D illustre la structure obtenue à l'issue d'une étape similaire à ce qui a été décrit précédemment en relation avec la figure 2E de formation, sur chaque LED L, d'une métallisation de contact 232L sur et en contact avec la face supérieure de la couche semiconductrice supérieure 103c de l'empilement actif 103 de la LED, et, sur chaque photodiode P, d'une métallisation de contact 232P sur et en contact avec la face supérieure de la couche semiconductrice supérieure 103c de l'empilement actif 103 de la photodiode.

La figure 2E illustre en outre une étape de remplissage des tranchées 320 et de l'espace entre les LED L et les photodiodes P par un matériau électriquement isolant 234, par exemple de l'oxyde de silicium.

Après le remplissage, une étape de planarisation peut être mise en oeuvre, par exemple par polissage mécano-chimique (CMP), de façon que les métallisations de contact 232L, 232P affleurent au niveau de la face supérieure du matériau de remplissage 234.

La figure 3E illustre une étape similaire à ce qui a été décrit ci-dessus en relation avec la figure 2F, de report et de fixation de la structure de la figure 3D sur un circuit intégré de contrôle 110, et de retrait du substrat de support 101, et, éventuellement, de tout ou partie de l'empilement semiconducteur de support 210.

De façon similaire à ce qui a été décrit précédemment, des étapes ultérieures peuvent ensuite être mises en oeuvre pour reprendre un contact électrique individuel ou commun sur la couche semiconductrice supérieure 103a de l'empilement actif 103 de chaque LED L et de chaque photodiode P.

De façon similaire à ce qui a été décrit précédemment, le circuit de contrôle peut optionnellement être configuré pour piloter les LED et les photodiodes avec des densités de porteur adaptées à réduire le décalage entre le pic d'émission des LED et le pic d'absorption des photodiodes.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et de dimensions mentionnés dans la description.

En outre, bien que l'on ait décrit ci-dessus des exemples de réalisation dans lesquels les empilements actifs de LED et de photodiode 103 sont fixés sur le circuit intégré de contrôle par collage direct métal-métal pleine plaque ou par collage direct hybride métal-métal/diélectrique-diélectrique, les modes de réalisation décrits ne se limitent pas à ces exemples particuliers. Plus généralement, les empilements actifs de LED et de photodiode 103 peuvent être fixés sur le circuit intégré de contrôle par tout autre moyen, par exemple par collage direct oxyde-oxyde pleine plaque.

Par ailleurs, on notera que les premier et troisièmes modes de réalisation peuvent être combinés.

Enfin, la mise en oeuvre pratique des modes de réalisation et variantes décrits est à la portée de la personne du métier à partir des indications fonctionnelles données ci-dessus.

## Revendications

1. Procédé de fabrication d'un dispositif optoélectronique comportant au moins une LED (L) et au moins une photodiode (P), comprenant les étapes suivantes :
a) former un empilement semiconducteur (210) de support comprenant au moins une couche semiconductrice dopée (210b) ;
b) former simultanément, lors d'une étape d'épitaxie commune, un empilement actif semiconducteur (103) d'émission de la LED (L) et un empilement actif semiconducteur (103) de réception de la photodiode (P) ;
c) former des tranchées (220 ; 320) s'étendant verticalement à travers l'empilement de support (210) et délimitant latéralement au moins un premier plot de support (SL) et au moins un deuxième plot de support (SP),
dans lequel, à l'issue des étapes b) et c), l'empilement actif semiconducteur (103) d'émission de la LED (L) recouvre le premier plot de support (SL) et l'empilement actif (103) de réception de la photodiode (P) recouvre le deuxième plot de support (SP),
le procédé comprenant en outre, après l'étape c), une étape d) de porosification de ladite couche semiconductrice dopée (210b) dans le premier plot de support (SL) sans porosifier ladite couche semiconductrice dopée (210b) dans le deuxième plot de support (SP), ou une étape de porosification de ladite couche semiconductrice dopée (210b) dans le deuxième plot de support (SP) sans porosifier ladite couche semiconductrice dopée (210b) dans le premier plot de support (SL).

2. Procédé selon la revendication 1, dans lequel l'étape c) de formation des tranchées (220) à travers l'empilement de support (210) et l'étape d) de porosification de la couche semiconductrice dopée (210b) sont mises en oeuvre avant l'étape b) d'épitaxie de l'empilement actif semiconducteur (103) d'émission de la LED (L) et de l'empilement actif semiconducteur (103) de réception de la photodiode (P), et dans lequel, lors de l'étape d), ladite couche semiconductrice dopée (220b) est porosifiée dans le deuxième plot de support (SP) et n'est pas porosifiée dans le premier plot de support (SL).

3. Procédé selon la revendication 1, dans lequel l'étape c) de formation des tranchées (320) à travers l'empilement de support (210) est mise en oeuvre après l'étape b) d'épitaxie de l'empilement actif semiconducteur (103) d'émission de la LED (L) et de l'empilement actif semiconducteur (103) de réception de la photodiode (P), et dans lequel, lors de l'étape d), ladite couche semiconductrice dopée (220b) est porosifiée dans le premier plot de support (SL) et non dans le deuxième plot de support (SP).

4. Procédé selon la revendication 2, dans lequel, à l'étape d), les flancs de la couche semiconductrice dopée (210b) dans le deuxième plot (SP) sont mis en contact avec un électrolyte, tandis que les flancs de la couche semiconductrice dopée (210b) dans le premier plot (SL) sont protégés du contact avec l'électrolyte par une couche de protection.

5. Procédé selon la revendication 3, dans lequel, à l'étape d), les flancs de la couche semiconductrice dopée (210b) dans le premier plot (SL) sont mis en contact avec un électrolyte, tandis que les flancs de la couche semiconductrice dopée (210b) dans le deuxième plot (SP) sont protégés du contact avec l'électrolyte par une couche de protection.

6. Procédé selon l'une quelconque des revendications 1 à 5, dans lequel, à l'étape d), un courant de polarisation est appliqué à travers ladite couche semiconductrice dopée (210b).

7. Procédé selon l'une quelconque des revendications 1 à 6, comprenant, après les étapes b) et d), une étape de report et de fixation de la LED (L) et de la photodiode (P) sur une face d'un circuit intégré de contrôle (110) préalablement formé dans et sur un substrat semiconducteur (101).

8. Procédé selon la revendication 7, dans lequel lors de ladite étape de report et de fixation, la LED (L) et la photodiode (P) sont fixées sur ladite face du circuit intégré de contrôle (110) par collage moléculaire.

9. Procédé selon l'une quelconque des revendications 1 à 8, dans lequel les tranchées (220 ; 320) sont agencées de façon que les dimensions latérales de la LED (L) soient inférieures aux dimensions latérales de la photodiode (P).

10. Procédé selon l'une quelconque des revendications 1 à 9, dans lequel l'empilement actif semiconducteur (103) d'émission de la LED (L) et l'empilement actif semiconducteur (103) de réception de la photodiode (P) comprennent un ou plusieurs alliages semiconducteurs de type III-V ou II-VI.

11. Dispositif optoélectronique comportant au moins une LED (L) comprenant un empilement actif semiconducteur (103) d'émission et au moins une photodiode (P) comprenant un empilement actif semiconducteur (103) de réception, le dispositif comprenant en outre une couche semiconductrice dopée (210b) en vis à vis de la LED (L) et de la photodiode (P), dans lequel la couche semiconductrice dopée (210b) est poreuse en vis à vis de la LED (L) et non poreuse en vis à vis de la photodiode (P), ou dans lequel la couche semiconductrice dopée (210b) est poreuse en vis à vis de la photodiode (P) et non poreuse en vis à vis de la LED (L) .

12. Dispositif selon la revendication 11, comprenant en outre un circuit intégré de contrôle (110) sur une face duquel sont fixées la LED (L) et la photodiode (P), le circuit intégré de contrôle (110) étant adapté à piloter la LED avec une densité de courant plus élevée que celle de la photodiode (P).

13. Dispositif selon la revendication 12, dans lequel le circuit intégré de contrôle (110) est adapté à piloter la LED (L) avec une densité de courant au moins dix fois plus élevée que celle de la photodiode (P).

## Patentansprüche

1. Verfahren zur Herstellung einer optoelektronischen Vorrichtung, die wenigstens eine LED (L) und wenigstens eine Fotodiode (P) aufweist, wobei das Verfahren die folgenden Schritte aufweist:
a) Ausbilden eines Halbleiterträgerstapels (210) mit wenigstens einer dotierten Halbleiterschicht (210b);
b) gleichzeitiges Ausbilden, während eines gemeinsamen Epitaxieschrittes, eines aktiven Emissions-Halbleiterstapels (103) der LED (L) und eines aktiven Empfangs-Halbleiterstapels (103) der Fotodiode (P);
c) Ausbilden von Gräben (220; 320), die sich vertikal durch den Trägerstapel (210) erstrecken und seitlich wenigstens ein erstes Stützpad (SL) und wenigstens ein zweites Stützpad (SP) begrenzen,
wobei am Ende der Schritte b) und c) der aktive Emissions-Halbleiterstapel (103) der LED (L) das erste Stützpad (SL) bedeckt und der aktive Empfangsstapel (103) der Fotodiode (P) das zweite Stützpad (SP) bedeckt,
wobei das Verfahren ferner nach Schritt c) einen Schritt d) aufweist, und zwar der Porösmachung der dotierten Halbleiterschicht (210b) in dem ersten Stützpad (SL) ohne Porösmachung der dotierten Halbleiterschicht (210b) in dem zweiten Stützpad (SP) oder einen Schritt der Porösmachung der dotierten Halbleiterschicht (210b) in dem zweiten Stützpad (SP) ohne Porösmachung der dotierten Halbleiterschicht (210b) in dem ersten Stützpad (SL).

2. Verfahren nach Anspruch 1, wobei der Schritt c) des Ausbildens der Gräben (220) durch den Trägerstapel (210) und der Schritt d) des Porösmachens der dotierten Halbleiterschicht (210b) vor dem Schritt b) der Epitaxie des aktiven Emissions-Halbleiterstapels (103) der LED (L) und des aktiven Empfangs-Halbleiterstapels (103) der Fotodiode (P) durchgeführt werden, und wobei während des Schritts d) die dotierte Halbleiterschicht (220b) in dem zweiten Stützpad (SP) porös gemacht wird und nicht in dem ersten Stützpad (SL) porös gemacht wird.

3. Verfahren nach Anspruch 1, wobei der Schritt c) des Ausbildens der Gräben (320) durch den Trägerstapel (210) nach dem Schritt b) der Epitaxie des aktiven Emissionshalbleiterstapels (103) der LED (L) und des aktiven Empfangshalbleiterstapels (103) der Fotodiode (P) durchgeführt wird, und wobei während des Schritts d) die dotierte Halbleiterschicht (220b) in dem ersten Stützpad (SL) und nicht in dem zweiten Stützpad (SP) porös gemacht wird.

4. Verfahren nach Anspruch 2, wobei in Schritt d) die Seiten der dotierten Halbleiterschicht (210b) im zweiten Pad (SP) in Kontakt mit einem Elektrolyten gebracht werden, während die Seiten der dotierten Halbleiterschicht (210b) im ersten Pad (SL) durch eine Schutzschicht vor dem Kontakt mit dem Elektrolyten geschützt werden.

5. Verfahren nach Anspruch 3, wobei in Schritt d) die Seiten der dotierten Halbleiterschicht (210b) im ersten Pad (SL) in Kontakt mit einem Elektrolyten gebracht werden, während die Seiten der dotierten Halbleiterschicht (210b) im zweiten Pad (SP) durch eine Schutzschicht vor dem Kontakt mit dem Elektrolyten geschützt werden.

6. Verfahren nach einem der Ansprüche 1 bis 5, wobei in Schritt d) ein Vorspannungsstrom durch die dotierte Halbleiterschicht (210b) angelegt wird.

7. Verfahren nach einem der Ansprüche 1 bis 6, das nach den Schritten b) und d) einen Schritt des Übertragens und des Bondens der LED (L) und der Fotodiode (P) auf eine Oberfläche einer integrierten Steuerschaltung (110) aufweist, die zuvor in und auf einem Halbleitersubstrat (101) ausgebildet wurde.

8. Verfahren nach Anspruch 7, wobei während des Übertragungs- und Verbindungsschritts die LED (L) und die Fotodiode (P) durch molekulares Verbinden mit der Oberfläche der integrierten Steuerschaltung (110) verbunden werden.

9. Verfahren nach einem der Ansprüche 1 bis 8, wobei die Gräben (220; 320) angeordnet sind, so dass die seitlichen Abmessungen der LED (L) kleiner sind als die seitlichen Abmessungen der Fotodiode (P).

10. Verfahren nach einem der Ansprüche 1 bis 9, wobei der aktive Emissions-Halbleiterstapel (103) der LED (L) und der aktive Empfangs-Halbleiterstapel (103) der Fotodiode (P) aus einer oder mehreren Typ-III-V- oder II-VI-Halbleiterlegierungen bestehen.

11. Optoelektronische Vorrichtung mit wenigstens einer LED (L) mit einem aktiven Emissions-Halbleiterstapel (103) und wenigstens einer Fotodiode (P) mit einem aktiven Empfangs-Halbleiterstapel (103), wobei die Vorrichtung ferner eine dotierte Halbleiterschicht (210b) vor der LED (L) und der Fotodiode (P) aufweist, wobei die dotierte Halbleiterschicht (210b) vor der LED (L) porös und vor der Fotodiode (P) nicht porös ist, oder wobei die dotierte Halbleiterschicht (210b) vor der Fotodiode (P) porös und vor der LED (L) nicht porös ist.

12. Vorrichtung nach Anspruch 11, ferner aufweisend eine integrierte Steuerschaltung (110), auf deren Oberfläche die LED (L) und die Fotodiode (P) gebondet sind, wobei die integrierte Steuerschaltung (110) geeignet ist, die LED mit einer höheren Stromdichte als die der Fotodiode (P) zu betreiben.

13. Vorrichtung nach Anspruch 12, wobei die integrierte Steuerschaltung (110) eingerichtet ist zum Ansteuern der LED (L) mit einer Stromdichte, die mindestens zehnmal höher ist als die der Fotodiode (P).

## Claims

1. Method of manufacturing an optoelectronic device comprising at least one LED (L) and at least one photodiode (P), comprising the following steps:
a) forming a semiconductor support stack (210) comprising at least one doped semiconductor layer (210b);
b) simultaneously forming, during a common epitaxy step, an active emission semiconductor stack (103) of the LED (L) and an active reception semiconductor stack (103) of the photodiode (P);
c) forming trenches (220; 320) vertically extending through the support stack (210) and laterally delimiting at least one first support pad (SL) and at least one second support pad (SP),
wherein, at the end of steps b) and c), the active emission semiconductor stack (103) of the LED (L) covers the first support pad (SL) and the active reception stack (103) of the photodiode (P) covers the second support pad (SP),
le method further comprising, after step c), a step d) of porosification of said doped semiconductor layer (210b) in the first support pad (SL) without porosifying said doped semiconductor layer (210b) in the second support pad (SP), or a step of porosification of said doped semiconductor layer (210b) in the second support pad (SP) without porosifying said doped semiconductor layer (210b) in the first support pad (SL).

2. Method according to claim 1, wherein step c) of forming of the trenches (220) through the support stack (210) and step d) of porosification of the doped semiconductor layer (210b) are implemented before step b) of epitaxy of the active emission semiconductor stack (103) of the LED (L) and of the active reception semiconductor stack (103) of the photodiode (P), and wherein, during step d), said doped semiconductor layer (220b) is porosified in the second support pad (SP) and is not porosified in the first support pad (SL).

3. Method according to claim 1, wherein step c) of forming of the trenches (320) through the support stack (210) is implemented after step b) of epitaxy of the active emission semiconductor stack (103) of the LED (L) and of the active reception semiconductor stack (103) of the photodiode (P), and wherein, during step d), said doped semiconductor layer (220b) is porosified in the first support pad (SL) and not in the second support pad (SP).

4. Method according to claim 2, wherein, at step d), the sides of the doped semiconductor layer (210b) in the second pad (SP) are placed into contact with an electrolyte, while the sides of the doped semiconductor layer (210b) in the first pad (SL) are protected from the contact with the electrolyte by a protection layer.

5. Method according to claim 3, wherein, at step d), the sides of the doped semiconductor layer (210b) in the first pad (SL) are placed into contact with an electrolyte, while the sides of the doped semiconductor layer (210b) in the second pad (SP) are protected from the contact with the electrolyte by a protection layer.

6. Method according to any of claims 1 to 5, wherein, at step d), a bias current is applied through said doped semiconductor layer (210b).

7. Method according to any of claims 1 to 6, comprising, after steps b) and d), a step of transfer and of bonding of the LED (L) and of the photodiode (P) onto a surface of an integrated control circuit (110) previously formed inside and on top of a semiconductor substrate (101).

8. Method according to claim 7, wherein during said transfer and bonding step, the LED (L) and the photodiode (P) are bonded to said surface of the integrated control circuit (110) by molecular bonding.

9. Method according to any of claims 1 to 8, wherein the trenches (220; 320) are arranged so that the lateral dimensions of the LED (L) are smaller than the lateral dimensions of the photodiode (P).

10. Method according to any of claims 1 to 9, wherein the active emission semiconductor stack (103) of the LED (L) and the active reception semiconductor stack (103) of the photodiode (P) comprise one or a plurality of type-III-V or II-VI semiconductor alloys.

11. Optoelectronic device comprising at least one LED (L) comprising an active emission semiconductor stack (103) and at least one photodiode (P) comprising an active reception semiconductor stack (103), the device further comprising a doped semiconductor layer (210b) in front of the LED (L) and of the photodiode (P), wherein the doped semiconductor layer (210b) is porous in front of the LED (L) and non-porous in front of the photodiode (P), or wherein the doped semiconductor layer (210b) is porous in front of the photodiode (P) and non-porous in front of the LED (L).

12. Device according to claim 11, further comprising an integrated control circuit (110) on a surface of which are bonded the LED (L) and the photodiode (P), the integrated control circuit (110) being adapted to driving the LED with a current density higher than that of the photodiode (P).

13. Device according to claim 12, wherein the integrated control circuit (110) is adapted to driving the LED (L) with a current density at least ten times higher than that of the photodiode (P).
